(19) **Europäisches Patentamt**

**European Patent Office**

**Office européen des brevets**

(11) **EP 0 879 113 B1**

(12) **EUROPEAN PATENT SPECIFICATION**

(45) Date of publication and mention
of the grant of the patent:
**26.05.2004 Bulletin 2004/22**

(51) Int Cl.⁷: **B23K 26/06**, G03F 7/42,
H01L 21/311
// B29D11/00

(21) Application number: **96935312.7**

(22) Date of filing: **04.11.1996**

(86) International application number:
**PCT/IL1996/000139**

(87) International publication number:
**WO 1997/017164 (15.05.1997 Gazette 1997/21)**

(54) **DAMAGE-FREE LASER SURFACE TREATMENT METHOD**

SCHONENDES LASER-FLÄCHENBEARBEITUNGSVERFAHREN

PROCEDE DE TRAITEMENT DE SURFACE AU LASER SANS EFFET SECONDAIRE NEGATIF

(84) Designated Contracting States:
**BE CH DE FR GB IE IT LI NL SE**

(30) Priority: **09.11.1995 IL 11593295**

(43) Date of publication of application:
**25.11.1998 Bulletin 1998/48**

(73) Proprietor: **Oramir Semiconductor Equipment
Ltd.
31000 Haifa (IL)**

(72) Inventors:
• **LIVSHITS (BUYANER), Boris
21940 Carmiel (IL)**

• **GENUT, Menachem
34815 Haifa (IL)**
• **TEHAR-ZAHAV, Ofer
42311 Natania (IL)**

(74) Representative: **Modiano, Guido, Dr.-Ing. et al
Modiano, Josif, Pisanty & Staub,
Baaderstrasse 3
80469 München (DE)**

(56) References cited:
**WO-A-92/03977        US-A- 5 114 834**

## Description

## Field of the Invention

The present invention relates to a method as per preamble of claim 1. More particularly, the invention relates to a method for preventing damages to substrates of any kind which require surface laser treatments, such as VLSI/ULSI circuits, during laser stripping or cleaning.

The invention also relates to an apparatus as per preamble of claim 9. An example of such method and apparatus is described in US-A-5114834.

## BACKGROUND OF THE INVENTION

In the manufacturing of various products it is necessary to apply a layer of protective material on a surface, which must be removed after a specified manufacturing step has been concluded. An example of such process is the so-called "masking", where a pattern is created on a surface using a layer of protective material illuminated through a mask, and the surface is then treated with a developer which removes material from the unmasked portions of the surface, therefore leaving a predetermined pattern. The surface is then treated by ion implantation or by etching agents, which introduce the implanted species into the unmasked portions of the surface, or removes material from unmasked portions. Once these processes are completed, the role of the protecting mask ends and it must be removed. The process is conventional and well known in the art, and is described, e.g., in U.S. Patent No. 5,114,834.

Two main photoresist stripping methods exist in the modem VLSI/ULSI (Very/Ultra Large Scale Integration) circuits industry:

1) Wet stripping which uses acids or organic solvents;
2) Dry stripping, which uses plasma, $O_3$, $O_3/N_2O$ or U.V./$O_3$-based stripping.

Both methods are problematic and far from being complete, especially when taking into consideration the future miniaturization in the VLSI/ULSI industry. The current technology is capable of dealing with devices having feature sizes of about 0.5 μm, but before the end of the century the expectation is that the workable size of the devices is expected to be reduced to 0.25 μm. The expected size changes require considerable changes in the manufacturing technology, particularly in the stripping stage. The prior art photoresist stripping techniques described above will be unsuitable for future devices, as explained hereinafter.

Utilizing only the wet stripping method is not a perfect solution, as it cannot completely strip photoresist after tough processes that change the chemical and physical properties of the photoresist in a way that it makes its removal very difficult. Such processes include, e.g., High Dose Implantation (HDI), reactive Ion Etching (RIE), deep U.V. curing and high temperatures post-bake. After HDI or RIE the side walls of the implanted patterns or of the etched walls are the most difficult to remove.

In addition, the wet method has some other problems: the strength of stripping solution changes with time, the accumulated contamination in solution can be a source of particles which adversely affect the performance of the wafer, the corrosive and toxic content of stripping chemicals imposes high handling and disposal costs, and liquid phase surface tension and mass transport tend to make photoresist removal uneven and difficult.

The dry method also suffers from some major drawbacks, especially from metallic and particulate contamination, damage due to plasma: charges, currents, electric fields and plasma-induced U.V. radiation, as well as temperature-induced damage, and, especially, incomplete removal. During various fabrication stages, as discussed above, the photoresist suffers from chemical and physical changes which harden it, and this makes the stripping processes of the prior art extremely difficult to carry out. Usually a plurality of sequential steps, involving wet and dry processes are needed to remove completely the photoresist.

The art has addressed this problem in many ways, and commercial photoresist dry removal apparatus is available, which uses different technologies. For instance, UV ashers are sold, e.g. by Hitachi™, Japan (UA-3150A), dry chemical ashers are also available, e. g., by Fusion Semiconductor Systems™, U.S.A., which utilize nitrous oxide and ozone to remove the photoresist by chemical ashing, microwave plasma ashing is also effected, e.g., as in the UNA-200 Asher™ (ULVAC™ Japan Ltd.). Also plasma photoresist removal is employed and is commercially available, e.g., as in the Aspen™ apparatus (Mattson Technology™, U.S.A.), and in the AURA 200™ (GASONICS IPC™, U.S.A.).

More recently, photoresist removal has been achieved by ablation, using laser UV radiation, in an oxidizing environment, as described in U.S. Patent No. 5,114,834. The ablation process is caused by strong absorption of the laser pulse energy by the photoresist. The process is a localized ejection of the photoresist layer to the ambient gas, associated with a blast wave due to chemical bonds breaking in the photoresist and instant heating. The partly gasified and partly fragmented photoresist is blown upwards away from the surface, and instantly heats the ambient gas. Fast combustion of the ablation products occurs, due to the blast wave and may also be due to the photochemical reaction of the UV laser radiation and the process gases. The main essence of the process is laser ablation with combustion of the ablated photoresist which occurs in a reactive gas flowing through an irradiation zone. The combination of laser radiation and fast combustion provides instantaneous lowering of the ablation threshold of hard parts of the photoresist (side walls). The combusted ablation products are then removed by vacuum suction, or by gas sweeping leaving a completely clean surface.

While US 5,114,834 provides an important novel process, it still does not provide a high throughput, which is industrially convenient, viz., an industrially acceptable number of wafers that can be stripped during a given time. The laser stripping throughput is determined by the stripping rate or by the number of laser pulses needed for providing complete stripping of a unit area of the photoresist per unit of time.

While reference will be made throughout this specification to the ablation of photoresist from semiconductor wafers, this will be done for the sake of simplicity, and because it represents a well known and widely approached problem. It should be understood, however, that the invention described hereinafter is by no means limited to the stripping of photoresist from wafers, but it applies, *mutatis mutandis*, to many other applications, such as stripping and cleaning of photoresist from Flat Panel Displays (FPD) or removal of residues from different objects, such as lenses, semiconductor wafers, or photo-masks.

WO 92/03977 discloses a laser catheter system for removing body tissue, which comprises a plurality of optical fibers, each having a proximal and a distal end, and a laser system optically coupled to said proximal end, which may comprise an optical extender. The separation between pulses is greater than the relaxation time of the avalanche process in the optical fiber but less than the tissue memory, whereby sufficient energy is transmitted to the body without damaging the optical fiber. The removing body tissue and the preventing from damage optical fiber are on the different surfaces and do not have thermal or mechanical contact.

The aforementioned US Patent 5,114,834 defines the process window of laser stripping and indicates that there are certain energy fluence levels of the laser pulse which may damage the wafer being treated. So far, however, the art has failed to provide a method which conveniently permits to utilize the energy of an excimer laser in a way that allows to increase the fluence damage threshold defined in US Patent 5,114,834, without incurring the risk of damaging the surface of the object being treated. The types of damage due to laser energy include thermal damages, such as ripples due in particular to difference in expansion coefficients, e.g., $SiO_2$/Si (implanted) and TiN/Al interfaces and related to the fatigue phenomena, aluminum or silicon melting, as well as radiation (ionization) damages, e.g., slight color changes due to small changes in the crystalline structure at $SiO_2$/Si interface (implanted).

In addition to laser stripping and cleaning there are other processes utilizing U.V. laser treatment of semiconductors or other materials where damage prevention may be important.

## SUMMARY OF THE INVENTION

It has now been found, and this is an object of the invention, that it is possible to avoid damage to the substrate being laser treated by extending the laser pulse in time, supplying the same pulse energy to the treated surface during a longer period of time.

The invention provides a method for preventing surface damage of a substrate in the ablation of photoresists from substrates by U.V. laser treatment, in the presence of a reactive gas and wherein the U.V. laser is pulsed, characterized in that it comprises extending the laser pulses before they reach the surface from which the photoresists are to be ablated, so that the said surface is common for the said substrate prevented from damage and the said photoresist removed from substrate.

The invention further comprises apparatus for preventing surface damage in an object being laser treated. Said device comprises a laser source for generating a laser pulse, means for extending the laser pulse before it reaches the surface to be treated, and means for homogenizing the pulse.

According to a preferred embodiment of the invention the device further comprises means for diverting the laser beam, and the means for extending the laser pulse are optical mean, which extends the laser pulse duration by 2 to 20 times.

In addition to the reduced damage benefits from pulse extension regarding the substrate, one should pay attention to the same benefits to the optical components as lenses, mirrors, etc.

Other objects of the invention will become apparent as the description proceeds.

## BRIEF DESCRIPTION OF THE DRAWINGS

In the drawings:

- Fig. 1 schematically illustrates the effect of pulse extension;

- Fig. 2 schematically illustrates the effect of pulse homogenization;

- Fig. 3 illustrates the process window (discussed in detail in the examples) for stripping photoresist after metal etching, wherein:

    Fig. 3(a) shows the process window without homogenization or pulse extension;
    Fig. 3(b) shows the process window with homogenization and without pulse extension; and
    Fig. 3(c) shows the process window with homogenization and with pulse extension.

- Fig. 4 illustrates an optical line arrangement consisting of a Pulse Extender (P.E.) and a Homogenizer, according to a preferred embodiment of the invention; and

- Fig. 5 is another optical line arrangement, consisting of a Homogenizer only.

The term "process window" indicates the set of conditions (number of pulses and energy fluence of each pulse) in which it is permitted to operate without causing damage to the substrate.

## DETAILED DESCRIPTION OF THE INVENTION

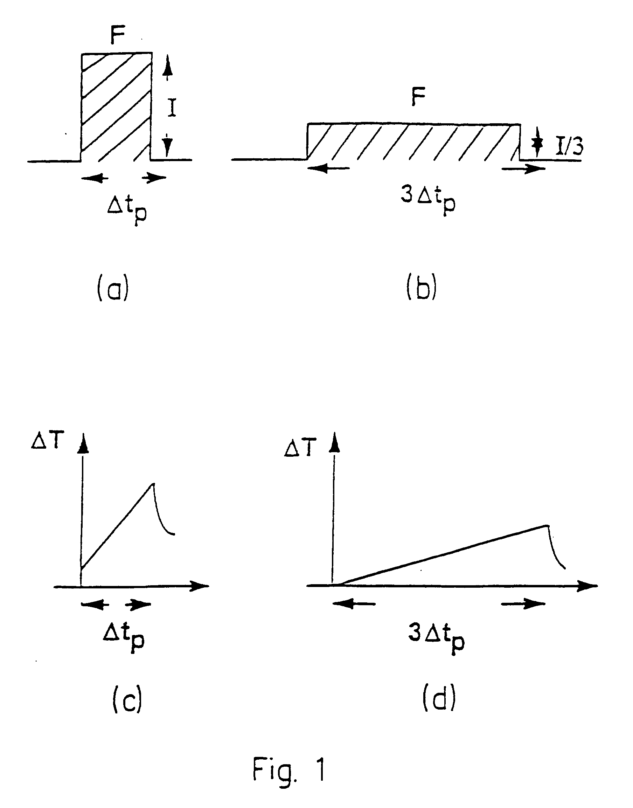

The method for avoiding surface damage of an object being treated by laser, according to the invention, comprises extending the laser pulse generated by a laser, before it reaches the surface to be treated. The situation so obtained is illustrated in Fig. 1. Fig. 1(a) shows an unextended pulse, which is extended by three times in Fig. 1(b). As a result, the pulse fluence (defined as F = E/S where E is the pulse energy on the surface of substrate and S is the treated area) is not changed, but the maximum temperature (T) on a surface of substrate (silicon) diminish by $\sqrt{3}$ times in accordance with equation (1):

$$T \approx \frac{F}{\sqrt{\Delta t_p}} \qquad (1)$$

due to thermal diffusion in silicon. In Eq. (1), $\Delta$tp is the pulse duration.

In Fig. 1(c), heat is produced by the pulse which, as explained herein before , may be one of the causes of damage to the surface. The resulted heat is reduced by a factor of $\sqrt{3}$, as schematically shown in Fig. 1(d), which relates to an extended pulse of Fig. 1 (b). The resulted damage fluence is:

$$\widetilde{F} = \widetilde{F}_0 \sqrt{\frac{\Delta t_p}{(\Delta t_p)_0}} = \sqrt{m}\,\widetilde{F}_0 \qquad (2)$$

where $\widetilde{F}_0$ and $(\Delta t_p)_0$, $\widetilde{F}$ and $\Delta t_p$, are accordingly the damage threshold fluences and the pulse duration before and after the pulse extension by m times.

On the other hand, the amount of ionization defects is proportional, as experiments show, to the pulse power density $F/\Delta t_p$ or to its square.

Therefore, the ionization damage diminishes by m or $m^2$ times as the pulse extended by m times, and the power density is reduced by m times. Accordingly, the damage threshold fluence rises by m or $m^2$ times.

When taking into consideration the fatigue phenomena, i.e.,, with the multipulsed irradiation of the same place of treated surface, in fact, the value of damage threshold fluence for an extended pulse rather should be shifted to a direction of process window decrease.

It should be emphasized that, in accordance with experimental data, the pulse extension up to $\Delta t_p$ $\cong 0.5$ microsecond produces only a weak change of ablation threshold fluence (10-20%) (low boundary of fluence working values). Consequently, the conclusion is that a pulse extension leads to a significant enlargement of the process window. Thus, the pulse extension provides a more effective ablation with higher values of laser fluence, without causing any damage to the substrate.

According to a preferred embodiment of the invention, the pulse is extended in the range of 20 times.

The pulse extension can be effected by any suitable method. however, according to a preferred embodiment of the invention, the pulse extension is optimized.

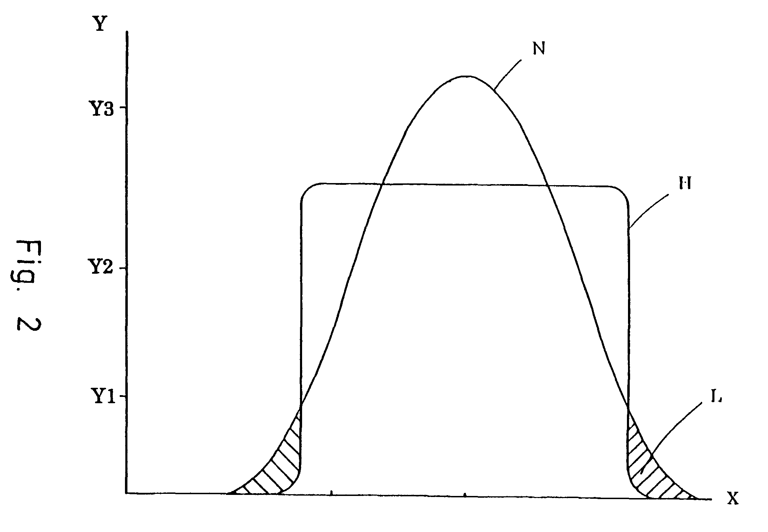

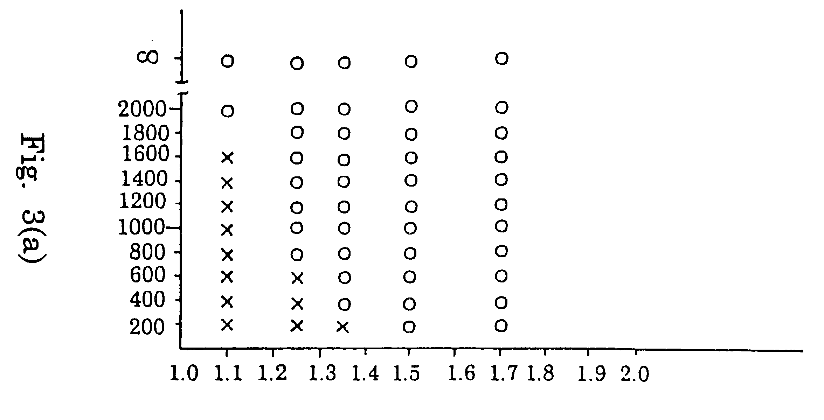

According to the invention, the pulse is also homogenized since, without it, its extension may not be enough to prevent damage. This is due to high values of fluence in the central part of the energy fluence surface distribution curve (see the non-homogenized pulse N in Fig. 2, where the ordinate is the fluence and Y1, Y2 and Y3 indicate the ablation threshold, the damage threshold before the pulse extension and the damage threshold after the pulse extension, respectively). The homogenized pulse H has a lower energy fluence for a given area (lower than the damage threshold)and has no areas of energy below the ablation threshold (indicated by "L") which not only does not aid ablation, but, on the contrary, hardens the photoresist by its annealing, and makes additional ablation difficulties.

Manufactures of commercial excimer lasers to date do not provide considerable variation of the duration of the laser pulse in the range of $10^{-8}$-$10^{-6}$s. Therefore, in order to assure damage-free laser treatment process, it is needed to join the laser and the optical pulse extender. However, it is not excluded that the pulse extension and/or homogenization be achieved inside the excimer laser.

As with the pulse extension, the pulse homogenization can be carried out by means of any suitable means known in the art. According to a preferred embodiment of the invention, however, homogenization is achieved by optical means. Such a type of pulse extender, as well as homogenizer, as was used by the inventors, is commercially available from "Exitech Ltd.", Oxford, UK.

The above and other characteristics and advantages of the invention will be better understood through the following illustrative and non-limitative examples.

### Example 1 (Comparative)

The substrate consisted of $SiO_2$/Si implanted areas which are known to be very sensitive to laser radiation. A wafer covered with a layer of high dose implanted, $1.2\,\mu m$ thick, patterned positive photoresist. Implantation conditions were: dose of $5\times10^{15}$ atoms/cm$^2$ and energy of 80 Kev was treated in a process chamber consisting of a cell as described in a copending Israeli patent application of the same applicant herein, IL 115934, which was equipped with a quartz window for UV light passage, gas inlet and outlet, and optics to position the laser beam at a predetermined location.

The process was operated according to U.S. Patent 5,114,834, using ozone as the reactive gas. The pressure in the chamber was maintained at 340 mbar. The laser employed was a Lambda Physik LPX315IMC excimer laser. The wafer was subjected to 150 pulses with fluence of 3 $F_{th}$ ($F_{th}$ is the ablation threshold fluence) and pulse duration of 25ns and its surface was then examined for damages. Noticeable color change which is due to color center was observed on the substrate on the uncored implanted areas. In addition, one could observe severe rippled areas due to interfacial deformations of the interface.

### Example 2

Operating as in Example 1, but using a pulse extension of 6 times, which means pulse duration of 6 x 25 = 150 ns, the surface was found not to have suffered any of the abovementioned damages.

### Example 3

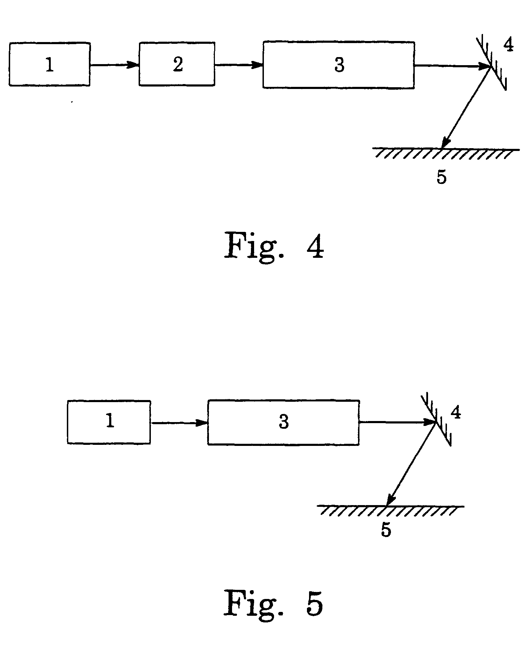

The arrangement is shown in Fig. 4. Numerals 1, 2, 3, 4 and 5 indicate the laser, the pulse extender, the homogenizer, the mirror and the substrate, respectively. The apparatus is same as described in Example 2, but with a homogenizer after the pulse extension. Working with the same fluence (3 $F_{th}$), no damage could be observed without effecting the stripping process. In addition, no damage observed even when the energy fluence levels were $\sqrt{6}(3F_{th}) \cong 7F_{th}$. This means a drastic enlargement of the process window.

### Example 4 (Comparative)

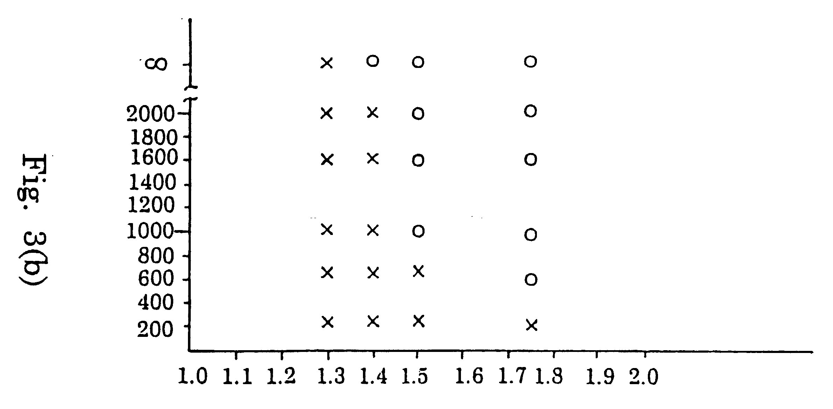

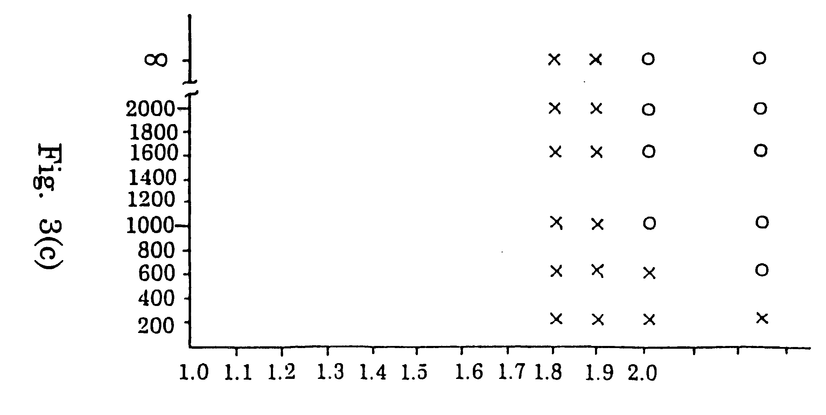

In the process of VLSI or VLSI fabrication, a silicon wafer after an RIE process of the metal, covered with a photoresist in the areas not to be etched, was treated in a process chamber consisting of a cell as described in the aforementioned copending Israeli patent application No. 115934, which was equipped and operated as described in Example 1. The pulse duration was 25 ns. The wafer was subjected to lower pulses and energy fluences as shown in the diagram in Fig. 3a.

The diagram shows the damage occurred (such as ripples or melting) as a function of the number of pulses given, and the level of energy fluence. The abscissa is the fluence given here as the ratio between the actual fluence (F) and the ablation threshold fluence and the ordinate is the number of pulses. Damage is indicated by o whereas a lack of damage ("no damage") is indicated by x.

It can be observed that even at such a low fluence level as $F/F_{th}$ = 1.1, damage occurs at 2000 pulses which is the total number of pulses needed for stripping. the photoresist on the metal etches at this fluence level. As it will be understood by persons skilled in the art, this is a too narrow process window for practical purposes, since no stripping takes place below the threshold value.

### Example 5 (Comparative)

The arrangement the same as described in Example 4 with an additional homogenizer. The arrangement is shown in Fig. 5, where numerals 1, 3, 4 and 5 indicate the laser, the homogenizer, the mirror and the substrate, respectively. The results are shown in Fig. 3b, where the various notations have the same meanings as in Fig. 3a. It can be can seen that no damage occurred up to $F/F_{th}$ = 1.3. At this fluence level, damage occurred only above $\sim10^4$ pulses, which is indicated here as $\infty$. At $F/F_{th}$ = 1.5, damage was found after 1000 pulses. This indicates a significant increase in the process window of about 36%, although at this fluence levels the throughput is not sufficient and one must find ways to be able to work at higher fluence levels.

### Example 6

Same as Example 5, but the laser pulse was extended x3, as shown schematically in Fig. 4.

The results are shown in Fig. 3c, where the various notations have the same meanings as in Fig. 3a It can be seen that no damage occurred at fluence levels of $F/F_{th}$ <2.

At $F/F_{th}$ = 2, damage occurred only after 1000 pulses. This indicates an increase of 82% in the process window relative to Example 4 and 33% relative to Example 5. Working at this fluence level makes ablation very efficient and with reasonable throughput.

This increase of the damage threshold is as expected from the 3 times extension according to Example 2. Therefore, one can expect to double the damage threshold in Fig. 3c if the pulse will be extended x 12. This means that a process window of up to $F/F_{th} \approx 4$.

All the above description and examples have been given for the purpose of illustration, and are not intended to limit the invention in any way, except as defined in the appended claims. Many different methods can be used to homogenize and/or extend the pulse, and different apparatus can be exploited for this purpose, for surface cleaning of a variety of objects, all without exceeding the scope of the invention.

**Claims**

1. A method for preventing surface damage of a substrate in the stripping of photoresists from substrates by pulsed U.V. laser surface treatment, in the presence of reactive gas, **characterized in that** it comprises extending the laser pulses before they reach the surface from which the photoresists are to be stripped.

2. A method according to claim 1, wherein the pulse duration is extended by 2-20 times.

3. A method according to claim 1, wherein pulse extension is effected by optical means

4. A method according to claim 1, further comprising homogenizing the pulse.

5. A method according to claim 4, wherein homogenization is achieved by optical means.

6. A method according to any one of claims 1 to 5, wherein the substrate is chosen from among semiconductor wafers and flat panel displays.

7. A method according to claim 1, wherein the substrate is a product on a surface of which a layer of protective material has been applied.

8. A method according to claim 7, wherein the substrate is a VLSI/ULSI circuit.

9. Apparatus for preventing surface damage of a substrate in the stripping of photoresists from substrates (5) by U.V. laser surface treatment in reactive gas atmosphere, which comprises means (1) for generating a pulsed U.V. laser and means (4) for directing the pulses onto the surface to be treated, **characterized in that** it further comprises:

   - means (2) for extending the laser pulses before they reach the surface from which the photoresists are to be stripped; and
   - optionally, means (3) for homogenizing the pulses.

10. Apparatus according to claim 9, wherein the means (3) for homogenizing the pulses are not integral with the means (2) for extending the pulses, and are external and coupled to the apparatus.

11. Apparatus for preventing surface damage in an object being laser treated according to claim 9 or 10, further comprising means for diverting the laser beam.

12. Apparatus according to claim 9 wherein the means for extending the laser pulses are optical means.

13. Apparatus according to any one of claims 9 to 12 comprising means for extending the laser pulse duration by 2 to 20 times.

**Patentansprüche**

1. Ein Verfahren zum Verhindern der Oberflächen-Beschädigung eines Substrates beim Entfernen von Fotolacken von Substraten durch gepulste UV-Laser-Oberflächenbehandlung, unter Vorhandensein von reaktivem Gas, **gekennzeichnet dadurch, dass** es die Verlängerung der Laser-Impulse, bevor sie die Oberfläche erreichen, von der die Fotolacke entfernt werden sollen, umfasst.

2. Ein Verfahren gemäß Anspruch 1, worin die Impuls-Dauer um das Zwei- bis Zwanzigfache verlängert wird.

3. Ein Verfahren gemäß Anspruch 1, worin die Impuls-Verlängerung durch optische Mittel durchgeführt wird.

4. Ein Verfahren gemäß Anspruch 1, das weiterhin die Homogenisierung des Impulses umfasst.

5. Ein Verfahren gemäß Anspruch 4, worin die Homogenisierung durch optische Mittel erreicht wird.

6. Ein Verfahren gemäß einem der Ansprüche 1 bis 5, worin das Substrat aus Halbleiter-Wafern und Flachbildschirmen gewählt wird.

7. Ein Verfahren gemäß Anspruch 1, worin das Substrat ein Produkt auf einer Oberfläche ist, vom dem eine Schicht von Schutzmaterial aufgetragen wurde.

8. Ein Verfahren gemäß Anspruch 7, worin das Substrat eine VLSI/ULSI-Schaltung ist.

9. Vorrichtung zum Verhindern der Oberflächen-Beschädigung eines Substrats beim Entfernen von Fotolacken von Substraten (5), durch UV-Laser-Oberflächenbehandlung in einer Atmosphäre reaktiven Gases, die Mittel (1) zum Generieren eines gepulsten UV-Lasers und Mittel (4) zum Richten der Impulse auf die zu behandelnde Oberfläche umfasst, **gekennzeichnet dadurch, dass** sie weiter Folgendes umfasst:

   - Mittel (2) zum Verlängern der Laser-Impulse, bevor sie die Oberfläche erreichen, von der die Fotolacke entfernt werden sollen; und
   - wahlweise Mittel (3) zum Homogenisieren der Impulse.

10. Vorrichtung gemäß Anspruch 9, worin die Mittel (3) zum Homogenisieren der Impulse nicht integral mit den Mitteln (2) zur Verlängerung der Impulse sind und worin sie extern und an die Vorrichtung gekoppelt sind.

11. Vorrichtung zum Verhindern der Oberflächen-Beschädigung bei einem Objekt, das mit Laser behandelt wird, gemäß Anspruch 9 oder 10, wobei die Vorrichtung weiterhin Mittel zum Umlenken des Laserstrahls umfasst.

12. Vorrichtung gemäß Anspruch 9, worin die Mittel zum Verlängern der Laser-Impulse optische Mittel sind.

13. Vorrichtung gemäß einem der Ansprüche 9 bis 12, die Mittel zum Verlängern der Laser-Impuls-Dauer um das Zwei- bis Zwanzigfache umfasst.

## Revendications

1. Procédé pour empêcher l'endommagement de la surface d'un substrat lors du décapage de résines photosensibles par traitement de surface par laser à ultraviolets pulsés, en présence de gaz réactif, **caractérisé en ce qu'**il comprend l'extension des impulsions laser avant qu'elles n'atteignent la surface à partir de laquelle les résines photosensibles doivent être décapées.

2. Procédé selon la revendication 1, dans lequel la durée d'impulsion est étendue de 2 à 20 fois.

3. Procédé selon la revendication 1, dans lequel l'extension des impulsions est effectuée par des moyens optiques.

4. Procédé selon la revendication 1, comprenant en outre l'homogénéisation de l'impulsion.

5. Procédé selon la revendication 4, dans lequel l'homogénéisation est réalisée par des moyens optiques.

6. Procédé selon l'une quelconque des revendications 1 à 5, dans lequel le substrat est choisi parmi des tranches de semi-conducteurs et des écrans plats.

7. Procédé selon la revendication 1, dans lequel le substrat est un produit sur une surface duquel une couche de matériau protecteur a été appliquée.

8. Procédé selon la revendication 7, dans lequel le substrat est un circuit VLSI/ULSI.

9. Appareil pour empêcher l'endommagement de la surface d'un substrat lors du décapage de résines photosensibles de substrats (5) par traitement de surface par laser à ultraviolets pulsés dans une atmosphère de gaz réactif, qui comprend des moyens (1) pour générer un laser à ultraviolets pulsés et des moyens (4) pour diriger les impulsions sur la surface à traiter, **caractérisé en ce qu'**il comprend en outre :

- des moyens (2) pour étendre les impulsions laser avant qu'elles n'atteignent la surface à partir de laquelle les résines photosensibles doivent être décapées ;
- optionnellement, des moyens (3) pour homogénéiser les impulsions.

10. Appareil selon la revendication 9, dans lequel les moyens (3) pour homogénéiser les impulsions ne font pas partie intégrante des moyens (2) pour étendre les impulsions, et sont externes et couplés à l'appareil.

11. Appareil pour empêcher l'endommagement de surface dans un objet traité au laser selon la revendication 9 ou 10, comprenant en outre des moyens pour dérouter le faisceau laser.

12. Appareil selon la revendication 9, dans lequel les moyens pour étendre les impulsions laser sont des moyens optiques.

13. Appareil selon l'une quelconque des revendications 9 à 12 comprenant des moyens pour étendre la durée de l'impulsion laser de 2 à 20 fois.

Fig. 1

Fig. 2

Fig. 3(a)

Fig. 3(b)

Fig. 3(c)

Fig. 4

Fig. 5